# EUROPEAN PATENT APPLICATION

(11) **EP 1 205 759 A1**
(43) Date of publication of application: **15.05.2002**
(21) Application number: 00310084.9
(22) Date of filing: 13.11.2000
(51) Int. Cl.: G01R 31/3185

(54) **Method for achieving scan testability of an integrated circuit including multiple clock domain**

(71) Applicant: LUCENT TECHNOLOGIES INC., Murray Hill, New Jersey 07974-0636 (US)
(72) Inventor: Knaeblein, Joachim, 91052 Erlangen (DE); Schmid, Josef, 92318 Neumarkt (DE)
(74) Representative: Buckley, Christopher Simon Thirsk

(57) **Abstract**

The invention illustrates a possibility for optimizing the scan testability of an integrated circuit including a plurality of different clock systems within a complex arrangement of a combinational logic layer and a storage layer. Therefore the invention proposes a method as well as an integrated circuit, wherein the integrated circuit is analysed to identifying logic circuitry's (LOGIC) each of which is passed by at least one clock domain transition path, and subsequently additional storage elements (SE) are inserted within the combinational layer at a logic circuitry (LOGIC) identified

## Description

The present invention relates to a method for achieving scan testability of an integrated circuit including multiple clock systems as well as to an integrated circuit with multiple clock systems having logic circuitry and a scan chain inserted for testability.

As known in the art integrated circuits (IC) especially with a very or ultra large scale integration (VLSI or ULSI) to be used for complex circuit or system solutions like application specific integrated circuits (ASIC) or systems on chips (SOC) usually require multi clock design styles for functional and/or performance reasons. Especially in the field of telecommunication applications several different requirements, as for example the handling of multi data channels, of data paths, of micro controller interfaces and/or of power management result in many complex clock structures causing clock domain transitions between respective different clock systems.

For achieving testability of such integrated circuits or even integrated systems with regard to their functionality and performances different scan testing methods are well known. In the European Patent application EP-A-0 965 850 filed by the same applicant as for the present application a scan test implementation is described, wherein additional storage elements are arranged within the scan chains formed by multiplexed scan flip-flops in front of or behind the functional flip-flops at locations where domain transitions between at least two of the functional flip-flops occur.

As it is described in that prior application the additional storage elements themselves can be based on a level sensitive latch or on a combination of an edge sensitive flip-flop with a multiplexer. Such an insertion of additional storage elements within the scan chains allows a simple circuitry model for an automatic test pattern generator (ATPG) because skew problems between different test clocks are eliminated and the circuitry can be considered to be synchronous when applying timesets to the test control signals.

However, depending on the specific structure of integrated circuits or even integrated systems to be tested a plurality of additional storage elements may be required since each path between respective two flip-flops comprising a clock domain transition have to be modified or treated by placing an additional storage element in the scan chain to function as a response storage element or as a stimuli storage element in test mode.

Accordingly, it is one object of the present invention to illustrate a possibility which is new and considerably improved over the prior art for optimizing the scan testability of an integrated circuit including a plurality of different clock systems within a complex arrangement of a combinational logic layer and a storage layer used to form scan chains for testability.

The inventive solution of the object is characterized by providing a method incorporating the features of claim 1 as well as by providing an integrated circuit incorporating the features of claim 7. Advantageous and preferred refinements and/or developments are the subject-matter of the respective dependent claims.

According to the invention it is proposed to analyze such an integrated circuit with regard to clock domain transition paths for identifying combinational logic circuitry's passed by said clock domain transition paths and by subsequently inserting respective additional storage elements within the combinational logic layer at any combinational logic circuitry identified.

An advantage of the present invention is that the amount of additional storage elements to be inserted for providing a test synchronous and skewless behavior can be reduced, since each inserted additional storage element causes a test synchronous and skewless behavior of all paths passing through such a modified combinational logic circuitry. Accordingly, the entire costs for providing scan testability may be enormously decreased as the consequence.

According to a preferred embodiment of the invention the adaptation of the combinational logic layer is started with the respective combinational logic circuitry passed by the most clock domain transition paths identified. By inserting an additional storage element each of the paths passing through is treated.

For a further optimization the amount of the clock domain transition paths to be modified could be reduced by using additional timesets.

For praxis it has been turned out that the best optimization can be achieved by starting with the clock system having the greatest difference between the number of domain transition paths coming to and the number of domain transition paths leaving from and by subsequently clocking that clock system with a predefined order of test clocks which best suits to the respective topology.

In the following text the invention will be described in detail by way of example and with regard to the accompanying drawings of which:
Fig. 1 is a schematic diagram of an example of a topology of an integrated circuit,
Fig. 2 is a schematic diagram of the integrated circuit according to Fig. 1 incorporating the inventive optimization approach for scan testability, and
Fig. 3 is a schematic diagram of the integrated circuit according to Fig. 1 incorporating a previous approach for achieving scan testability.

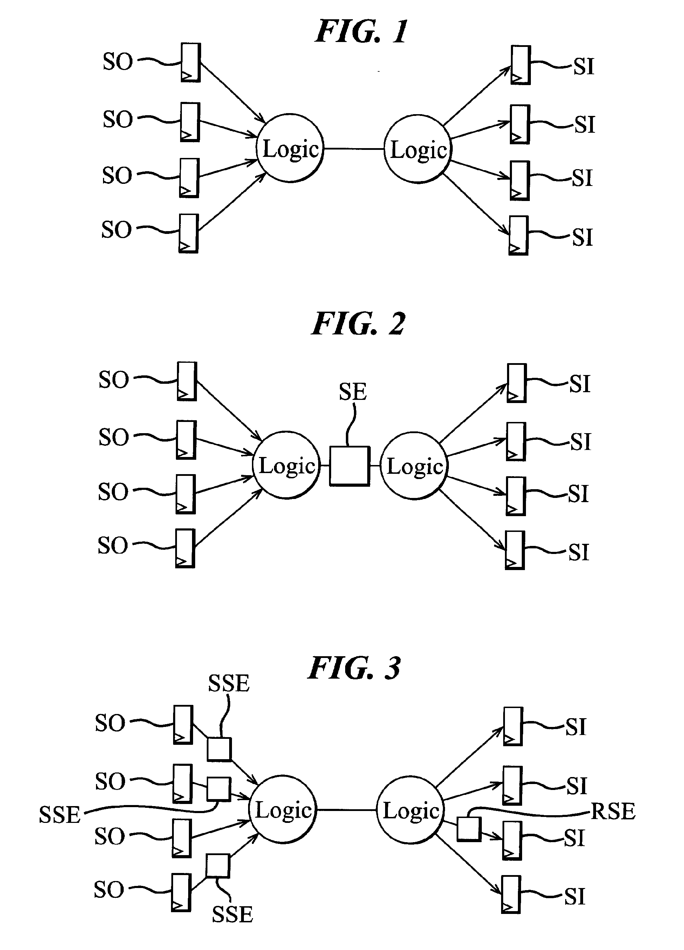

For the following detail description by way of illustration only an exemplary topology of an integrated circuit is depicted in Fig. 1. A plurality of source flip-flops SO feed via logic circuitry's LOGIC of a combinational logic layer into multiple sink flip-flops SI. The source flip-flops SO and the sink flip-flops SI are clocked by different clock sources with clock domain transitions there between. Thus, a plurality of clock domain transition paths are formed between the source flip-flops SO and the sink flip-flops SI. Furthermore, it has to be mentioned, that positive edge triggering and negative edge triggering are be seen as being different clocks.

However, for a better understanding of the underlying problems caused by such a clock domain transition path reference is made to the above-mentioned prior European Patent application EP-A-0 965 850 forming the base of the current inventive approach for optimizing the scan testability. Thus, the disclosure of that prior application is entirely incorporated to the subject matter of the disclosure of the present application.

Consequently, using the previous approach described in that basis application and adapting the proposed implementation of additional storage elements to the topology according to Fig. 1 may result in a modified structure of the topology as depicted in Fig. 3. Within each clock domain transition path formed between the plurality of source flip-flops SO and the plurality of sink flip-flops SI an additional storage element based on a latch or on a flip-flop is inserted directly in front of a sink flip-flop SI as an additional response storing element RSE and/or directly behind a source flip-flop SO as an additional stimuli storing element SSE.

In contrast to that known way of implementation by inserting the additional storage elements as being parts of the scan chains, the inventive approach results in an simplification of the topology of an integrated circuit modified for scan testability in that an additional storage element SE may be inserted within the combinational logic layer. As a consequence, with the implementation of one additional storage element SE suitably basing on a latch or a flip-flop design a plurality of domain transition paths can be treated as shown for example at Fig. 2.

With other words the amount of additional storage elements SE to be inserted is substantially reduced in comparison to the prior necessary amount of additional storage elements if the topology of the integrated circuit is comprising different clock domain transition paths passing through at least one common combinational logic circuitry LOGIC. By placing an additional storage element at that common combinational logic circuitry each of the clock domain transition paths passing through is treated.

If, however, the topology of the integrated circuit is such that a common combinational logic circuitry is not realizable then the maximal number of additional storage elements necessary to be inserted at worst is equal to the necessary number of additional storage elements according to the prior approach.

Therefore, for identifying a circuitry to be treaded to optimize scan testability implementation, the integrated circuit at first has to be analyzed with regard to clock domain transitions and to identify clock domain transition paths. This can be done for example by analyzing a net list as known for people skilled in the art. A result of such a net list analysis is a list of the clock domain transition paths and accordingly a list of the respective combinational logic circuitry's passed by each transition path.

Subsequently, for reducing the necessary amount of additional storage elements in that merely one additional storage element SE for testability reason is inserted within each transition path the combinational logic circuitry having the most passing transition paths is identified. By inserting an additional storage element at that circuitry each of the clock domain transition paths passing are treated and, subsequently, may be removed from the aforementioned generated list of paths. Then the procedure of identifying the next suitable combinational logic circuitry passed by the most of the remaining clock domain transition paths is restarted until all transition paths are modified and the integrated circuit can be considered as being synchronous.

The necessary amount of additional storage elements can be further reduced by applying additional timesets such that clock domain transitions do not cause a stimuli or response capturing problem. Therefore, a suitable order of test clocks for the specific topology of the circuit should be defined prior to the treatment of the remaining transition paths by means of additional storage elements. However, it should be noted that for each additional timeset to be used an additional test pin for that timeset has to be provided.

For each additional timeset that can be realized a respective clock system having the most difference in number between the clock domain transition paths to and the clock domain transition paths from is identified.

In case that more clock domain transition paths are leaving from the such identified clock system with regard to clock domain transition paths coming thereto, the clock system is put in order for the latest available timing. Furthermore, each test clock subsequently assigned to be late is provided with an earlier timing than the timing of a clock previously assigned to be late. It should be noted that the terms early and late refer to the moment of the clock pulse edge during a clock cycle.

In case, however, that more clock domain transition paths are coming to the identified clock system with regard to clock domain transition paths leaving from, the clock system is put in order for the earliest available timing. And accordingly, each clock subsequently assigned to be early is provided with a later timing than the timing of clocks previously assigned to be early.

As long as additional timesets can be realized the procedure of clock alignment is restarted by identifying a further clock system having the greatest difference between the number of remaining clock domain transition paths to and the number of remaining clock domain transition paths from.

As mentioned, all clock domain transition paths treated by a respective clock alignment can be removed from the generated path list prior to restart the clock alignment procedure and consequently prior to the treatment of the remaining transition paths by means of additional storage elements to be inserted.

It has to be mentioned, that depending on the specific test tools to be used especially for analyzing the generated list of paths with regard to the respective combinational logic circuitry's passed by clock domain transition paths or for generating the test pattern after the insertion of the additional storage elements within the combinational logic layer some modifications might be possible or even necessary. For a person skilled in the art, however, it should be obvious that several modifications can be carried out without departing from the protective scope of the invention.

## Claims

1. Method for achieving scan testability of an integrated circuit including multiple clock systems incorporated within a combinational layer of logic circuitry's (LOGIC) and a storage layer, using the storage layer to form a scan chain for testability,
**characterized by** the steps of:
- analysing the integrated circuit to identify clock domain transition paths,
- identifying logic circuitry's (LOGIC) each of which is passed by at least one clock domain transition path, and
- inserting an additional storage element (SE) within the combinational layer at a logic circuitry (LOGIC) identified.

2. Method according to claim 1, **characterized by** the step of
- identifying the respective logic circuitry (LOGIC) passed by the most clock domain transition paths for inserting the additional storage element at said logic circuitry

3. Method according to claim 1 or 2, **characterized in that** the number of identified clock domain transition paths are reduced prior to the step of insertion by using additional timesets.

4. Method according to claim 3 wherein for each additional timeset to be used a respective clock system having the most difference in number between the clock domain transition paths to and from is identified.

5. Method according to claim 4 **characterized by** assigning a clock system having more clock domain transition paths leaving in stimuli direction to a later timing within an clock cycle than a clock system having more paths in response direction.

6. Method according to claim 4 **characterized by** assigning a clock system having more clock domain transition paths in a response direction to an earlier timing within an clock cycle than a clock system having more paths leaving in stimuli direction.

7. Integrated circuit including multiple clock systems incorporated within a combinational layer of logic circuitry's (LOGIC) and a storage layer **characterized by** additional storage elements (SE) placed within the combinational layer at locations having clock domain transitions.

8. Integrated circuit according to claim 7, wherein the additional storage elements (SE) are placed at logic circuitry's (LOGIC) passed by at least one clock domain transition path.

9. Integrated circuit according to claim 7 or 8, wherein an additional storage element (SE) is based on a latch design.

10. Integrated circuit according to claim 7 or 8, wherein an additional storage element (SE) is based on a flip-flop design.
